# EUROPÄISCHE PATENTSCHRIFT

(11) **EP 0 691 715 B1**
(45) Veröffentlichungstag und Bekanntmachung des Hinweises auf die Patenterteilung: **19.09.2001**
(21) Anmeldenummer: 95108562.0
(22) Anmeldetag: 03.06.1995
(51) Int. Cl.: H01S 3/06, C03C 13/04

(54) **Lichtwellenleiter für faseroptische Verstärker für den Wellenlängenbereich um 1550 nm**
Optical waveguide for fibre-optic amplifier for wavelengths around 1550 nm
Guides d'ondes optiques pour amplificateurs à fibre optique dans la gamme des longueurs d'ondes autour de 1550 nm

(30) Priorität: 10.06.1994 DE 4420287
(43) Veröffentlichungstag der Anmeldung: 10.01.1996
(73) Patentinhaber: ALCATEL, 75008 Paris (FR)
(72) Erfinder: Weber, Dieter Dr., D-70806 Kornwestheim (DE)
(74) Vertreter: Kugler, Hermann, Dipl.-Phys.

(56) Entgegenhaltungen:
- EP-A- 0 371 629
- EP-A- 0 466 932
- WO-A-94/21010
- PATENT ABSTRACTS OF JAPAN vol. 015 no. 126 (C-0817) ,27.März 1991 & JP-A-03 008744 (SHIN ETSU CHEM CO LTD;OTHERS: 01) 16.Januar 1991,
- PATENT ABSTRACTS OF JAPAN vol. 016 no. 320 (C-0962) ,14.Juli 1992 & JP-A-04 092825 (FUJIKURA LTD) 25.März 1992,
- PATENT ABSTRACTS OF JAPAN vol. 012 no. 237 (C-509) ,6.Juli 1988 & JP-A-63 030343 (SUMITOMO ELECTRIC IND LTD) 9.Februar 1988,
- PATENT ABSTRACTS OF JAPAN Bd. 15, Nr. 500 (C-0895) 18 Dezember 1991 & JP 03 218 946 A (KOKUSAI DENSHIN DENWA CO LTD) 26 September 1991

## Beschreibung

Aus Journal of Lightwave Technology, Vol. 9, No. 2, February 1991, Seiten 220 - 227, ist es bekannt, daß Licht im Wellenlängenbereich um 1530 nm mit Lichtwellenleitern verstärkt werden kann, wenn diese im Kern als laseraktive Substanz Erbium enthalten. Hierauf beruhend existieren faseroptische Verstärker, die mit großem Erfolg in im Wellenlängenbereich um 1530 nm arbeitenden Systemen eingesetzt werden.

Bei den bekannten Verstärker-Lichtwellenleitern weist die Floureszenzbande, d.h. die über die Wellenlänge aufgetragene Verstärkung, ihren maximalen Wert im Bereich von 1530 nm auf. Diese Fluoreszenzbande ist jedoch nicht optimal, weil sie ein ausgeprägtes Maximum bei einer bestimmten Wellenlänge aufweist. Erwünscht wäre jedoch eine Fluoreszenzbande, bei der kein ausgeprägtes Maximum bei einer bestimmten Wellenlänge vorhanden ist, sondern bei der der Verlauf der Fluoreszenz über der Wellenlänge abgeflacht ist. Bei einem Verstärkungslichtwellenleiter mit dieser Eigenschaft kann ein größerer Wellenlängenbereich für die Nachrichtenübertragung verwendet werden. Aus derselben Veröffentlichung ist weiter bekannt, daß die Fluoreszenzbande beträchtlich verbreitert werden kann, wenn zusätzlich zu Erbium Aluminium im Kern enthalten ist.

Aus EP-A-0466932 ist es bekannt, in poröse Vorformen, die zu Glasstäben weiterverarbeitet werden, ein Fluorid eines Selten-Erd-Elementes einzubringen, weil die Fluoride relativ niedrige Schmelzpunkte haben (S. 8). Weiter ist es bekannt, die porösen Vorformen in einer Sauerstoffatmosphäre vor dem Sintern zu erhitzen und (S. 9, Zeilen 9-12) die porösen Vorformen in einer Sauerstoff enthaltenden Heliumatmosphäre zu sintern, derart daß die durch Sintern entstehenden Glasstäbe Erbium und Fluor enthalten, wobei Erbium mit Sauerstoff verbunden ist (Er₂O₃) (S. 11, Zeile 56).

Aus "Patent Abstracts of Japan", Vol. 15, no. 100 (C-0895), 18. Dez. 1991; PAT: A 32 18 946 ist ein Lichtwellenleiter bekannt, der mit dem Gegenstand der vorliegenden Erfindung die im nicht kennzeichnenden Teil des Anspruchs 1 oder des Anspruchs 2 angeführten Merkmale gemeinsam hat. Dort ist örtlich das dem Erbium-lon nahe Sauerstoff-Ion durch ein Anion wie F-, Cl- oder S₂- ersetzt, um die Asymmetrie des Ligandenfelds zu vergrößern. Das Ziel ist dort, den Wirkungsgrad der durch den Lichtwellenleiter möglichen Lichtverstärkung zu verbessern.

Dagegen besteht bei der vorliegenden Erfindung die Aufgabe, die Floureszenzbande des Lichtwellenleiters zu verbreitern und abzuflachen.

Dieses technische Problem wird wie im Patentanspruch 1 oder 2 angegeben gelöst.

Weiterbildungen der Erfindung sind in den Unteransprüchen angegeben. Ein vorteilhaftes Verfahren zur Herstellung des neuen Lichtwellenleiters ist Gegenstand der Ansprüche 4 bis 6. Ein Aspekt der Erfindung ist auch, daß durch den neuen Lichtwellenleiter ein neuer faseroptischer Verstärker geschaffen wurde. Dieser ist Gegenstand des Anspruchs 7.

Vorteilhafte Einzelheiten der Erfindung sind in den Figuren 1 bis 3 gezeigt. Es zeigen:
- Fig. 1: einen faseroptischen Verstärker für den Wellenlängenbereich um 1550 nm mit dem neuen Lichtwellenleiter als verstärkendem Lichtwellenleiter,
- Fig. 2: Die Fluoreszenzbande eines erfindungsgemäßen Verstärker-Lichtwellenleiters und
- Fig. 3: eine Vorrichtung zur Durchführung des Verfahrens zur Herstellung des Verstärker-Lichtwellenleiters.

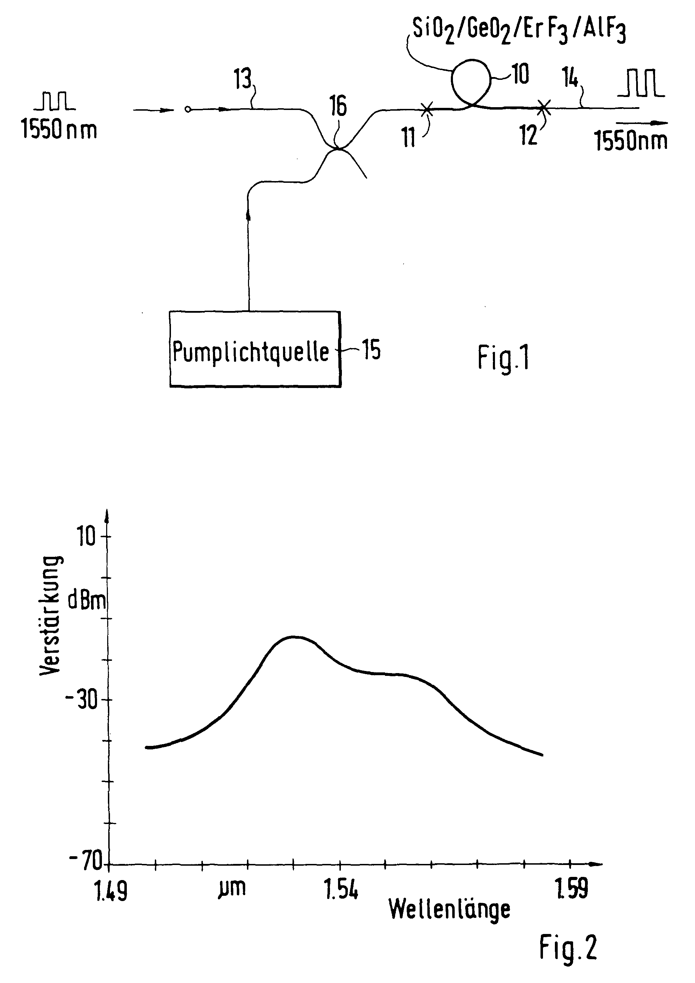

In Fig. 1 ist mit dem Bezugszeichen 10 ein schematisch angedeuteter Verstärker-Lichtwellenleiter eines faseroptischen Verstärkers bezeichnet. An Spleißpunkten 11 und 12 ist er mit einem Lichtwellenleiter 13, der das zu verstärkende optische Eingangssignal leitet bzw. mit einem Lichtwellenleiter 14, der das verstärkte optische Ausgangssignal des faseroptischen Verstärkers leitet, verbunden. Wie für faseroptische Verstärker üblich, ist eine Pumplichtquelle 15 vorhanden, die in dem gezeigten Fall über einen Koppler 16 an den Lichtwellenleiter 13 angekoppelt ist. Wie bei solchen Darstellungen oft üblich, ist der Verstärkungs-Lichtwellenleiter 10 zur Unterscheidung von den normalen Lichtwellenleitern 13 und 14 dicker gezeichnet, obwohl er den gleichen Durchmesser hat. Die Wellenlänge des einen solchen faseroptischen Verstärker durchlaufenden Lichts liegt im Bereich von 1550 nm. Als Signal ist am Eingang ein Digitalsignal angedeutet, ebenso am Ausgang, wobei es am Ausgang als verstärktes Signal dargestellt ist.

Wesentlich für die Erfindung ist, daß der Lichtwellenleiter, der als verstärkender Lichtwellenleiter für den 1550 nm-Bereich vorgesehen ist, folgende Zusammensetzung hat:

Siliziumdioxyd ist das Grundmaterial des gesamten Lichtwellenleiters; wie üblich ist im Kern des Lichtwellenleiters ein den Brechungsindex erhöhendes Dotiermittel, z.B. GeO₂ enthalten, weiter Erbium als faseraktive Substanz und Aluminium zur Verbreiterung der Erbium-Fluoreszenzbande, und erfindungsgemäß zusätzlich Fluor. Die Zusammensetzung des Mantels ist ohne Bedeutung. Wichtig ist, daß Erbium mit Fluor verbunden ist, d.h. daß Erbium von Fluorionen umgeben ist. Die Fluorionen dürfen nicht durch Sauerstoffionen verdrängt werden. Die Umgebung von Erbium mit Fluor bewirkt, daß das Erbium die gewünschte Lasereigenschaft hat, die für die Verstärkung von Licht im Wellenlängenbereich um 1550 nm erforderlich ist. Eine Möglichkeit, für die Umgebung von Erbium durch Fluor zu sorgen, besteht darin, daß Erbium und Fluor als Verbindung Erbiumtrifluorid (ErF₃) im Kern enthalten ist. Vorzugsweise ist auch Aluminium als Verbindung Aluminiumtrifluorid (AlF₃) im Kern enthalten.

Wie aus Fig. 2 zu erkennen ist, weist die Fluoreszenzbande bei dem erfindungsgemäßen Verstärker-Lichtwellenleiter über einen großen Bereich zwischen 1520 und 1560 nm nahezu konstante Intensität auf.

Zur Herstellung des erfindungsgemäßen Lichtwellenleiters ist jedes Verfahren geeignet, das dazu führt, Erbium, Aluminium und Fluor in Verbindung miteinander in den Kern eines Lichtwellenleiters mit Siliziumdioxyd als Grundmaterial einzulagern.

Besonders günstig ist ein Verfahren, bei dem Erbiumtrifluorid als Komplex mit Aluminiumtrifluorid dampfförmig zusammen mit Ausgangsstoffen einer chemischen Dampfphasenreaktion, aus der das Kernmaterial entsteht, in die Nähe eines Substrats gebracht wird, so daß es sich zusammen mit den Produkten der chemischen Dampfphasenreaktion auf dem Substrat niederschlagen kann. Beispielsweise kann die chemische Dampfphasenreaktion gemäß dem bekannten MCVD-Verfahren in einem Substratrohr durchgeführt werden, so daß das Substratrohr innen beschichtet wird. Ein solches Verfahren wird nachstehend als Beispiel für ein Verfahren der Abscheidung aus einer chemischen Dampfphasenreaktion erläutert.

Alternativ zu einem solchen MCVD-Verfahren, bei dem das Substrat ein Quarzglasrohr ist und innen beschichtet wird, kann bei dem Verfahren auch ein stabförmiger Dorn verwendet werden, der auf seiner Außenfläche beschichtet wird, oder es kann eine Unterlage sein, die sich um ihre Achse dreht, und auf der durch Beschichtung aus einer Dampfphasenreaktion in axialer Richtung das Kernglasmaterial und eventuell auch das Mantelglasmaterial entsteht. Das Prinzip dieser drei bekannten Varianten von Verfahren der Abscheidung aus einer chemischen Dampfphasenreaktion ist aus der Veröffentlichung "telecom report", 6 (1983) Beiheft: "Nachrichtenübertragung mit Licht", S. 29 - 35, bekannt.

Wesentlich für das hier bevorzugte Verfahren zur Herstellung des neuen Lichtwellenleiters ist, daß Erbiumfluorid zusammen mit Aluminiumtrifluorid und den Ausgangsstoffen der chemischen Dampfphasenreaktion, die zum Erzeugen des Kernglasmaterials verwendet wird, dem Substrat zugeleitet wird, damit es sich zusammen mit dem Produkt der chemischen Dampfphasenreaktion auf dem Substrat abscheiden kann.

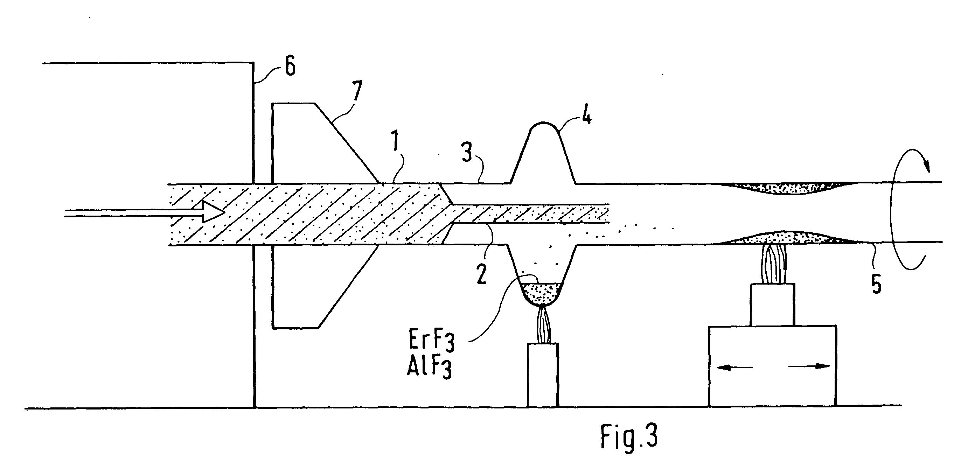

Ein Ausführungsbeispiel eines bevorzugten Verfahrens wird nachstehend anhand von Fig. 3 erläutert, die eine Vorrichtung zur Durchführung des Verfahrens zeigt.

Die Herstellung eines Verstärkungslichtwellenleiters erfolgt über eine Lichtwellenleiter-Vorform nach dem MCVD-Verfahren, welches in der Weise abläuft, daß ein in eine Glasdrehbank eingespanntes und rotierendes Substratrohr, welches in der Regel aus Quarzglas besteht, in mehreren Durchgängen mit den Mantel- bzw. Kernschichten aus einem künstlichen Glas beschichtet wird. Die Ausgangsstoffe für die Mantel- bzw. Kernschichten werden in Gasform in das Substratrohr geleitet. Durch die in Längsrichtung fortschreitende Erhitzung des Substratrohres durch einen Knallgasbrenner wird fortschreitend durch Abscheidung aus einer chemischen Dampfphasenreaktion auf der Innenwandung des Substratrohres eine künstliche Glasschicht bestimmter Zusammensetzung erzeugt. Die Länge des Substratrohres beträgt üblicherweise 1250 mm. Als Ausgangswerkstoffe für die Herstellung der Schichten aus künstlichem Glas werden beispielsweise Siliziumtetrachlorid (SiCl₄), Germaniumtetrachlorid (GeCl₄), Phosphoroxitrichlorid (OPCl₃) und gegebenenfalls Hexafluorethan (C₂F₆) zusammen mit Sauerstoff und Helium verwendet.

Die Figur 3 zeigt den Teil einer in einer Glasdrehbank eingespannten Vorrichtung für die Durchführung des erfindungsgemäßen Verfahrens. Diese Vorrichtung besteht aus dem Rohr 1 mit größerem Durchmesser am linken Ende. Sein Durchmesser entspricht etwa dem Durchmesser des Substratrohres 5. Das Rohr 1 verjüngt sich etwa in der Mitte der Vorrichtung - ihre Gesamtlänge beträgt etwa 350 mm- zu einem Rohr 2 mit kleinerem Durchmesser. Das Rohr 2 ist von einem anderen Rohr 3 mit größerem Durchmesser umgeben, welches am linken Ende verschlossen, mit dem Rohr 1 verbunden ist und eine rotationssymmetrische Verdickung 4 besitzt.

Am rechten Ende des Rohres 3 ist das zu beschichtende Substratrohr 5 angeschmolzen, welches beispielsweise eine Länge von 900 mm aufweist. Das linke Ende der Vorrichtung, d.h. das Rohr 1, ist drehbar in der Glasdrehbank 6 gelagert und wird von dem Antrieb 7 in Drehung versetzt.

Während des Betriebes der Vorrichtung sind in der Verdickung 4 die Werkstoffe enthalten, welche für die Durchführung des erfindungsgemäßen Verfahrens benötigt werden, und zwar Erbiumtrifluorid (ErF₃) und Aluminiumtrifluorid (AlF₃). Die Ausgangsstoffe Aluminiumtrifluorid und Erbiumtrifluorid sind in Pulverform erhältlich. Sie werden in die Verdickung eingefüllt. Während der Herstellung der Mantelglasschicht werden die Verdickung 4 und die darin enthaltenen Stoffe nicht erhitzt. Erst wenn die Kernschicht erzeugt werden soll, wird die Verdickung 4 und somit die darin enthaltenen Stoffe auf ca. 1350°C erhitzt. Dabei geht das Gemisch aus Erbiumtrifluorid und Aluminiumtrifluorid in die Gasphase über und wird von dem einströmenden Gas mitgerissen. Um das Elementfluoridsystem zu stabilisieren, kann eine fluoridhaltige Komponente, wie Hexafluorethan, mitgeführt werden. Die Komponenten Siliziumdioxid, Germaniumdioxid, Erbiumtrifluorid mit Aluminiumtrifluorid werden auf der Innenfläche des Substratrohres 5 abgeschieden und durch die nachfolgende Wärmequelle, z.B. einen Knallgasbrenner, verglast.

Bei der Durchführung des vorgeschlagenen Verfahrens zur Herstellung der Lichtwellenleiter-Vorform mit einer mit Erbium, Aluminium und Fluor dotierten Kernschicht hat es sich als zweckmäßig erwiesen, nach dem Erzeugen dieser Kernschicht in noch einem Durchgang eine weitere Kernschicht ohne die genannte Dotierung zu erzeugen und dann vor dem Kollabieren des Substratrohres etwa 70 % der Gesamtdicke der 1. und 2. Kernschicht abzuätzen, beispielsweise mit Hexafluorethan. Dadurch ergibt sich eine Anreicherung des Erbiums im Zentrum des Lichtwellenleiter-Kerns, wodurch der Verstärkereffekt verstärkt wird.

Statt Aluminium kann auch ein anderes Element im Kern enthalten sein. Geeignet ist jedes Element, das ähnlich wie Aluminium zur Glättung zur Fluoreszenzkurve beiträgt und andererseits in der Lage ist, eine Verbindung zu bilden, die mit ErF₃ einen Komplex bildet, damit ErF₃ bei relativ niedriger Temperatur (z.B. 1350°C) in die Dampfphase überführt werden kann. Möglich erscheint als ein solches Element Bor. Eine Verbindung von Bor mit Fluor, Bortrifluorid (BF₃), die bei Raumtemperatur gasförmig ist, kann über erhitztes ErF₃ geleitet werden und bildet mit ErF₃ einen Komplex, der dann gasförmig an den Ort der gewünschten Abscheidung auf einem Substrat geleitet wird.

## Patentansprüche

1. Lichtwellenleiter aus Siliziumdioxid als Grundmaterial, mit einem Kern und einem Mantel, mit einem oder mehreren den Brechungsindex erhöhenden Dotiermitteln und mit Erbium und daran gebundenem Fluor im Kern, **dadurch gekennzeichnet, daß** das Erbium nur von Fluorionen umgeben ist ohne daß Verbindungen von Erbium und Sauerstoff vorhanden sind, und daß der Kern Aluminium enthält.

2. Lichtwellenleiter aus Siliziumdioxid als Grundmaterial, mit einem Kern und einem Mantel, mit einem oder mehreren den Brechungsindex erhöhenden Dotiermitteln und mit Erbium und daran gebundenem Fluor im Kern, **dadurch gekennzeichnet, daß** das Erbium nur von Fluorionen umgeben ist ohne daß Verbindungen von Erbium und Sauerstoff vorhanden sind, und daß der Kern Bor oder ein Element, das in der Lage ist, eine Verbindung zu bilden, die mit Erbiumflourid einen Komplex bildet, enthält.

3. Lichtwellenleiter nach Anspruch 1 oder 2, **dadurch gekennzeichnet, daß** Erbium, Aluminium und Flour als Erbiumtriflourid (ErF₃) bzw. Aluminiumtriflourid im Kern enthalten sind.

4. Verfahren zur Herstellung eines Lichtwellenleiters nach einem der vorstehenden Ansprüche, bei dem das Kernmaterial und gegebenenfalls auch das Mantelmaterial durch Abscheidung aus einer chemischen Dampfphasenreaktion auf einem Substrat erzeugt und das erzeugte Material zu einem Lichtwellenleiter weiterverarbeitet wird,
**dadurch gekennzeichnet, daß** aus Erbiumtrifluorid (ErF₃) und einer anderen Verbindung ein Komplex gebildet und dampfförmig zusammen mit den Ausgangsstoffen der chemischen Dampfphasenreaktion dem Substrat zugeleitet wird, so daß auf diesem das Produkt der chemischen Dampfphasenreaktion und der Komplex abgeschieden werden.

5. Verfahren nach Anspruch 4,
**dadurch gekennzeichnet, daß** als Verbindung zur Bildung des Komplexes Aluminiumtrifluorid (AlF₃) oder Bortrifluorid (BF₃) oder eine andere Verbindung verwendet wird, die mit Erbiumtrifluorid (ErF₃) einen Komplex bildet.

6. Verfahren nach Anspruch 4 oder 5, bei dem als Substrat ein Quarzglasrohr verwendet wird und die Ausgangsstoffe der chemischen Dampfphasenreaktion in das Substratrohr eingeleitet werden,
**dadurch gekennzeichnet, daß** die Ausgangsstoffe der chemischen Dampfphasenreaktion zusammen mit dem in Dampfform gebrachten gebildeten Komplex in das Substratrohr eingeleitet werden, so daß durch Abscheidung des Produkts der chemischen Dampfphasenreaktion und des Komplexes das Substratrohr innen beschichtet wird, und daß das innen beschichtete Substratrohr in an sich bekannter Weise zu einem Lichtwellenleiter weiterverarbeitet wird.

7. Faseroptischer Verstärker (16, 10, 15) mit einem Lichtwellenleiter (10) als verstärkendem Element,
**dadurch gekennzeichnet, daß** der Lichtwellenleiter (10) die Merkmale eines der vorstehenden Ansprüche 1 bis 3 hat.

## Claims

1. An optical waveguide consisting of silicon dioxide as base material comprising a core and a cladding, with one or more doping agents which increase the refractive index, and with erbium and fluorine combined therewith in the core, **characterised in that** the erbium is surrounded only by fluorine ions without the presence of compounds of erbium and oxygen, and that the core contains aluminium.

2. An optical waveguide consisting of silicon dioxide as base material comprising a core and a cladding, with one or more doping agents which increase the refractive index, and with erbium and fluorine combined therewith in the core,
**characterised in that** the erbium is surrounded only by fluorine ions without the presence of compounds of erbium and oxygen, and that the core is boron or an element capable of forming a compound which forms a complex with erbium fluoride.

3. An optical waveguide according to Claim 1 or 2, **characterised in that** erbium, aluminium and fluorine are contained in the core in the form of erbium trifluoride (ErF₃) and aluminium trifluoride.

4. A method for manufacturing an optical waveguide according to one of the preceding claims, wherein the core material and optionally also the cladding material are produced on a substrate by precipitation from a chemical vapour-phase reaction and the produced material is further processed to form an optical waveguide, **characterised in that** a complex is formed from erbium trifluoride (ErF₃) and another compound and is conveyed to the substrate in vaporous form together with the starting materials of the chemical vapour-phase reaction, such that the product of the chemical vapour-phase reaction and the complex is precipitated on the substrate.

5. A method according to Claim 4, **characterised in that** aluminium trifluoride (AlF₃) or boron trifluoride (BF₃), or another compound which forms a complex with erbium trifluoride (ErF₃), is used as compound for forming the complex.

6. A method according to Claim 4 or 5, wherein a quartz glass tube is used as substrate and the starting materials of the chemical vapour-phase reaction are introduced into the substrate tube, **characterised in that** the starting materials of the chemical vapour-phase reaction are introduced into the substrate tube together with the formed complex brought into vaporous form, such that the interior of the substrate tube is coated as a result of the precipitation of the product of the chemical vapour-phase reaction and the complex, and that the internally coated substrate tube is further processed in known manner to form an optical waveguide.

7. A fibre-optic amplifier (16, 10, 15) with an optical waveguide (10) as amplifying element,
**characterised in that** the optical waveguide (10) has the features of one of the above claims 1 to 3.

## Revendications

1. Guide d'ondes optiques en dioxyde de silicium comme matériau de base, comprenant un coeur et une enveloppe, avec un ou plusieurs moyens de dopage augmentant l'indice de réfraction, et contenant dans le coeur de l'erbium et du fluor qui y est lié, **caractérisé en ce que** l'erbium est entouré uniquement par des ions de fluor sans aucun composé d'erbium et d'oxygène, et en ce que le coeur contient de l'aluminium.

2. Guide d'ondes optiques en dioxyde de silicium comme matériau de base, comprenant un coeur et une enveloppe, avec un ou plusieurs moyens de dopage augmentant l'indice de réfraction, et contenant dans le coeur de l'erbium et du fluor qui y est lié, **caractérisé en ce que** l'erbium est entouré uniquement par des ions de fluor sans aucun composé d'erbium et d'oxygène, et en ce que le coeur contient du bore ou un élément qui est en mesure de former un composé qui forme un complexe avec le fluorure d'erbium.

3. Guide d'ondes optiques selon la revendication 1 ou 2, **caractérisé en ce que** l'erbium, l'aluminium et le fluor sont contenus dans le coeur sous la forme du trifluorure d'erbium (ErF₃) ou du trifluorure d'aluminium.

4. Procédé pour la fabrication d'un guide d'ondes optiques selon l'une quelconque des revendications précédentes, dans lequel le matériau du coeur, et éventuellement aussi le matériau de l'enveloppe, est généré par dépôt sur un substrat à partir d'une réaction chimique en phase vapeur et le matériau généré est transformé en un guide d'ondes optiques, **caractérisé en ce qu'**un complexe est formé à partir du trifluorure d'erbium (ErF₃) et d'un autre composé et est amené au substrat sous forme de vapeur en même temps que les substances de départ de la réaction chimique en phase vapeur, de sorte que le produit de la réaction chimique en phase vapeur et le complexe puissent se déposer sur le substrat.

5. Procédé selon la revendication 4, **caractérisé en ce que** comme composé pour former le complexe, on utilise du trifluorure d'aluminium (AlF₃) ou du trifluorure de bore (BF₃) ou un autre composé qui forme un complexe avec le trifluorure d'erbium (ErF₃).

6. Procédé selon la revendication 4 ou 5, dans lequel un tube de verre quartzeux est utilisé comme substrat et les substances de départ de la réaction chimique en phase vapeur sont introduites dans le tube de substrat, **caractérisé en ce que** les substances de départ de la réaction chimique en phase vapeur sont introduites dans le tube de substrat en même temps que le complexe formé, amené à la phase vapeur, de sorte que le dépôt du produit de la réaction chimique en phase vapeur et du complexe recouvre le tube de substrat à l'intérieur, et en ce que le tube de substrat recouvert à l'intérieur est transformé en un guide d'ondes optiques de façon connue en soi.

7. Amplificateur à fibre optique (16, 10, 15) comprenant un guide d'ondes optiques (10) comme élément amplificateur, **caractérisé en ce que** le guide d'ondes optiques (10) présente les caractéristiques d'une des revendications précédentes 1 à 3.
